# EUROPEAN PATENT SPECIFICATION

(11) **EP 2 672 310 B1**
(45) Date of publication and mention of the grant of the patent: **06.01.2016**
(21) Application number: 12184167.0
(22) Date of filing: 13.09.2012
(51) Int. Cl.: G02B 19/00, F21V 5/00, H01L 33/58, G02B 27/09

(54) **Large-angle lens and large-angle emission led light source module**
Weitwinkellinse und Weitwinkelemissions-LED-Lichtquellenmodul
Objectif grand angle et module de source lumineuse DEL à émission grand angle

(30) Priority: 05.06.2012 CN 201210183866
(43) Date of publication of application: 11.12.2013
(73) Proprietor: Foshan Nationstar Optoelectronics Co., Ltd., Chan Cheng District FoShan Guangdong 528000 (CN)
(72) Inventor: Huang, Yangcheng, FoShan, Guangdong 528000 (CN); Wei, Cuie, FoShan, Guangdong 528000 (CN); Wang, Guilin, FoShan, Guangdong 528000 (CN); Lu, Weixian, FoShan, Guangdong 528000 (CN); Wu, Changqing, FoShan, Guangdong 528000 (CN); Huang, Shunguo, FoShan, Guangdong 528000 (CN)
(74) Representative: Rutz, Andrea

(56) References cited:
- EP-A1- 2 378 338
- WO-A1-2011/010535
- WO-A1-2012/011528
- CN-A- 102 080 805
- US-A1- 2011 141 734
- US-A1- 2011 164 426
- US-B1- 6 670 207

## Description

The present application claims the benefit of priority to Chinese patent application No. 201210183866.1 titled "LARGE-ANGLE LENS AND LARGE-ANGLE EMISSION LED LIGHT SOURCE MODULE", filed with the Chinese State Intellectual Property Office on June 5, 2012.

### FIELD OF THE INVENTION

The present disclosure relates to the field of LED encapsulation technology, and in particular to a large-angle lens and a large-angle emission LED light source module provided with the large-angle lens.

### BACKGROUND OF THE INVENTION

The LED light source has been paid attention to and applied widely at present due to its numerous advantages, such as small volume, low power consumption, long service life, high brightness and small heat. Therefore, the LED light source technique has been rapidly developed, and efforts have been made to enhance various performances of the LED light source through technical improvement.

The LED light source, which has a light distribution curve approximately conformable to Lambertian distribution, has a light beam angle of about 110°~120°, and is able to be applied in the common lighting occasion. However, the light beam angle is not large enough, and the utilization efficiency of the light energy is not high. To solve this technical problem, a secondary light distribution lens is used on the LED device in the LED light source module, and the emission angle is widened by designing the shape of the incident surface and the exit surface of the lens, so as to utilize the light energy effectively. In the existing lens technique, the effect of the light energy distribution and utilization is not very well. As such, the technical problem to be solved presently in the prior art is how to further optimize the design of the incident surface and the exit surface of the lens to further improve the emission angle of the lens. A lens according to the state of the art for use in combination with an LED light source is for example disclosed in US 2011/164426.

### SUMMARY OF THE INVENTION

In view of this, an object of the disclosure is to provide a large-angle lens according to claim 1, which may improve the light-emitting angle; and based on this, the disclosure further provides a large-angle emission LED light source module according to claim 7 provided with this large-angle lens.

To solve the above technical problems, technical solutions of the disclosure are as follows.

A large-angle LED lens includes a shell-shaped main body with an opening at the lower end. The main body has an incident surface on the inner side of the main body and an exit surface on the outer side of the main body. Both of the incident surface and the exit surface are provided symmetrically about the central axis of the main body, the incident surface being a transparent concave surface, and the exit surface being a transparent convex surface. The maximum thickness d1 of the main body at the lower part and the minimum thickness d2 of the main body at the top satisfy the relation: 4<dl/d2<6; the concave depth h1 of the transparent concave surface and the minimum thickness d2 of the main body at the top satisfy the relation: h1>4*d2; and the convex height h2 of the transparent convex surface and the minimum thickness d2 of the main body at the top satisfy the relation: h2>5*d2.

Preferably, the thickness of the main body gradually decreases from the lower part of the main body to the top of the main body.

Preferably, a mounting part is provided at the lower end of the main body, and the bottom of the mounting part being in contact with a substrate is provided with raised stripes.

Preferably, a mounting part is provided at the lower end of the main body. The mounting part includes a first mounting part located under the transparent convex surface and a second mounting part located under the transparent concave surface. The first mounting part is of a stepped structure extending from the lower end of the outer side of the main body in a direction away from the central axis of the main body, and the second mounting part is of a concave structure extending from the lower end of the inner side of the main body in a direction away from the central axis of the main body.

Preferably, the large-angle lens clings to the surface of the substrate tightly for covering the entire light-emitting surface of the LED device, and the plastic housing is formed on the upper surface of the substrate and around the substrate by die-casting or injection molding, so as to encapsulate the large-angle lens and the substrate.

Preferably, a mounting part is provided at the lower end of the main body, and the lower end of the mounting part is in contact with the substrate. The mounting part includes a first mounting part located under the transparent convex surface and a second mounting part located under the transparent concave surface. The fist mounting part is of a stepped structure extending from the lower end of the outer side of the main body in a direction away from the central axis of the main body, and the second mounting part is of a concave structure extending from the lower end of the inner side of the main body in a direction away from the central axis of the main body.

Preferably, the substrate is a metal core PCB plate.

Preferably, the plastic housing is formed with an open groove surrounding the large-angle lens. The exit surface of the large-angle lens is exposed out of the bottom surface of the groove, and the side surfaces of the open groove are inclined with respect to the bottom surface of the open groove.

Preferably, the side surfaces of the open groove are at an angle of 10°~52° with respect to the bottom surface of the open groove.

Preferably, the large-angle lens and the plastic housing are formed integrally.

Compared with the prior art, with the large-angle lens of the disclosure, the shapes of the transparent concave surface of the incident surface and the transparent convex surface of the exit surface are optimized, and the thicknesses at different parts of the main body are set, and the relations between the thickness of the top of the main body, the depth of the transparent concave surface and the height of the transparent convex surface are optimized, so that the light-emitting angle of the lens is improved significantly, and the light beam angle can be converted to be larger than 130°, thereby achieving the large-angle lighting while improving the lighting evenness; the designs of the transparent concave surface and the transparent convex surface minimize the probability of the total reflection, so that the increased light-emitting angle is ensured while ensuring the efficiency of the lens up to 90%, thereby maximizing the utilization of the light.

Further, in actual application, this structural arrangement of the mounting part located at the lower end of the main body can protect the LED device well. The lens covers the LED light-emitting surface, so that the LED device is protected better from being influenced by the external environment, thereby prolonging the service life of the device.

The large-angle lens of the disclosure applied to the LED light source module can increase the light-emitting angle of the entire LED light source module, thereby enlarging the illuminating area of the LED light source module. Thus, in practical application in the terminal, the arranging density of the LED light source module can be decreased, and the number of the LED light source module in use can be decreased, so that the labor mounting cost of the terminal and the production cost are decreased.

### BRIEF DESCRIPTION OF THE DRAWINGS

Figure 1 is a longitudinal sectional view of a large-angle lens of a first embodiment according to the disclosure;
Figure 2 is a schematic diagram of the overall structure of the large-angle lens in Fig. 1;
Figure 3 is another schematic diagram of the overall structure of the large-angle lens in Fig. 1;
Figure 4 is a schematic diagram of light paths of the large-angle lens in Fig. 1;
Figure 5 is a longitudinal sectional view of a large-angle lens of a second embodiment according to the disclosure;
Figure 6 is a longitudinal sectional view of a large-angle lens of a third embodiment according to the disclosure;
Figure 7 is a partially enlarged view of the large-angle lens in Fig. 6;
Figure 8 is a schematic structural diagram of a large-angle emission LED light source module of a first embodiment according to the disclosure;
Figure 9 is a longitudinal sectional view of the large-angle emission LED light source module in Fig. 8;
Figure 10 is a sectional view of fitting between the large-angle lens and the substrate in Fig. 8;
Figure 11 is a light curve distribution with Lambertian distribution produced by the LED light source module without the large-angle lens in Fig. 8;
Figure 12 is a light distribution curve of the large-angle emission LED light source module in Fig. 8;
Figure 13 is a schematic diagram of light emission of the LED light source module in use without the large-angle lens;
Figure 14 is a schematic diagram of light emission of the LED light source module in Fig. 8 in use;
Figure 15 is a schematic diagram of the overall structure of a large-angle emission LED light source module of a second embodiment according to the disclosure;
Figure 16 is a longitudinal sectional view of the large-angle emission LED light source module in Fig. 15;
Figure 17 is a schematic diagram of the overall structure of a large-angle emission LED light source module of a third embodiment according to the disclosure; and
Figure 18 is a sectional view of the large-angle emission LED light source module seeing from direction B in Fig. 17.

### DETAILED DESCRIPTION OF THE INVENTION

The disclosure will be described in further detail in conjunction with the drawings and the specific embodiments, in order that those skilled in the art will understand the technical solution of the disclosure better.

### First Embodiment of Large-angle Lens

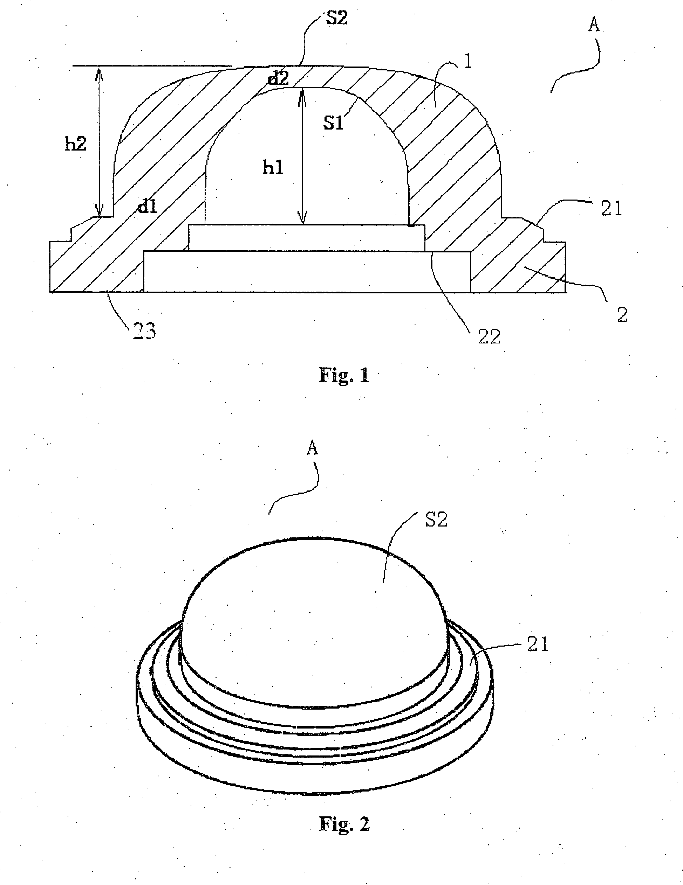

Referring to Figs. 1, 2 and 3, a large-angle lens A of this embodiment includes a shell-shaped main body 1 with an opening at the lower end, and a mounting part 2 that is provided at the lower part of the main body 1 and molded integrally with the main body 1. The main body 1 has an incident surface S1 and an exit surface S2. The incident surface S1 and the exit surface S2 are respectively provided symmetrically about the central axis of the main body. The large-angle lens of this embodiment is made of a transparent material.

The incident surface S1 is a transparent concave surface, which changes gradually from a cylindrical surface at the lower half part into a spherical surface, and then transits into a flat surface at the top smoothly.

The exit surface S2 is a transparent convex surface, which bends gradually toward the central axis of the main body from a cylindrical surface at the lower half part, and then becomes a flat surface at the top of the main body finally.

The thickness of the main body gradually decreases from down to up. The main body has a cylinder shape at the lower part. The thickness d1 of the lower part of the main body, which is even, is defined as the horizontal distance from the incident surface S1 to the exit surface S2, being the maximum thickness of the main body; and the minimum thickness d2 (i.e., the thickness of the centre of the lens) of the top of the main body, which is even, is defined as the distance from the top surface of the incident surface S1 to the top surface of the exit surface S2, being the minimum thickness of the whole main body; wherein d1 and d2 satisfy the relation: 4<dl/d2<6.

Further, the concave depth h1 of the transparent concave surface, i.e., the distance from the bottom to the highest point on the top of the transparent concave surface, and the thickness d2 of the centre of the lens satisfy the relation: h1>4*d2.

The convex height h2 of the transparent convex surface, i.e., the distance from the bottom to the highest point on the top of the transparent convex surface, and the thickness d2 of the centre of the lens satisfy the relation: h2>5*d2.

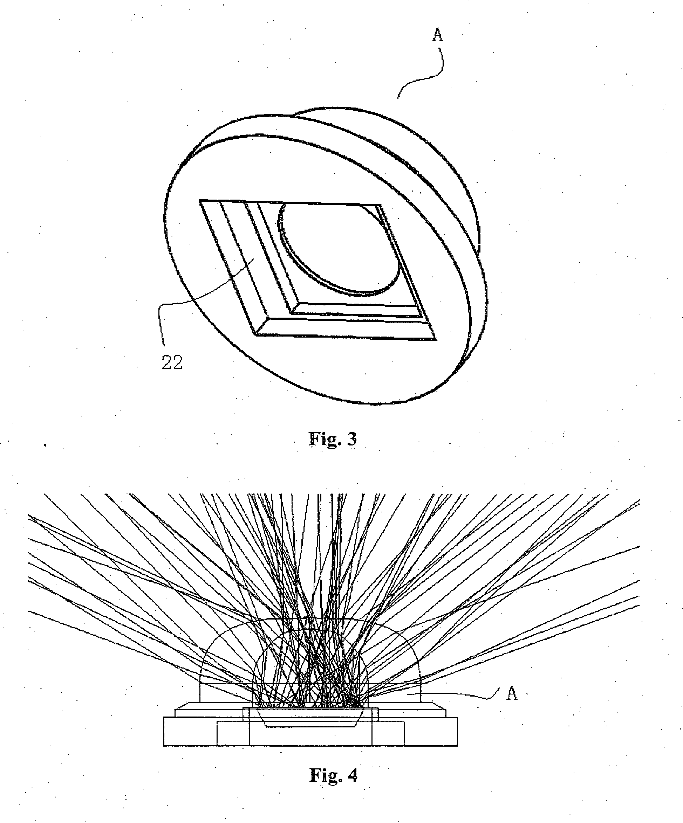

The light paths of the large-angle lens in this embodiment is shown in Fig. 4, which is **characterized in that** the light rays are deflected through the two transparent surfaces, i.e., the transparent concave surface and the transparent convex surface. In this way, the light rays are redistributed, so that more light rays are deflected from the axis, and most of the light rays passing through the lens have an exit angle equal to or larger than the exit angle of the light rays emitted from the light-emitting surface.

Further, with the large-angle lens of this embodiment, the increased emission angle is ensured and meanwhile the efficiency of the lens is ensured to go up to 90%, mainly because the two transparent surfaces, i.e., the transparent concave surface and the transparent convex surface, are designed such as to minimize the probability of the total reflection and thus to maximize the utilization of the light.

The mounting part 2 includes a first mounting part 21 and a second mounting part 22. The first mounting part 21 is provided near the transparent convex surface to facilitate the encapsulation of the large-angle lens and the substrate, and the second mounting part 22 is provided near the transparent concave surface to facilitate the mounting and the fixing of the LED device. The first mounting part 21 is of a stepped structure that is provided outside the lens and located at the lower part of the transparent convex surface. The entire stepped structure includes a flat surface, an inclined surface, a vertical surface, a flat surface and a vertical surface from up to down. The second mounting part 22 is of a concave structure that is provided inside the lens and located at the lower part of the transparent concave surface of the main body. The concave structure includes a flat surface, a vertical surface, a flat surface and a vertical surface from up to down.

In other embodiments, as a more preferred solution, several raised stripes, such as helical stripes, are provided on the bottom 23 of the mounting part, so that the light emitted to the bottom can be reflected back to the lens, so as to increase the utilization of the light energy.

### Second Embodiment of Large-angle Lens

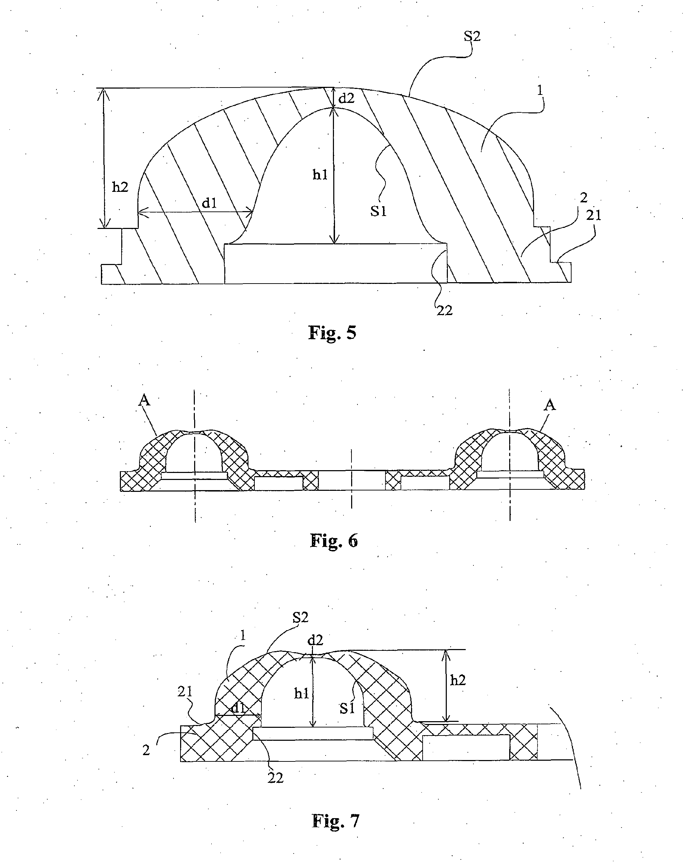

Referring to Fig. 5, the large-angle lens in this embodiment includes a main body 1 and a mounting part 2 that is provided under the main body 1. The main body 1 has an incident surface S1 and an exit surface S2 which both are provided with respect to a central axis circumferentially and symmetrically. The mounting part 2 includes a first mounting part 21 and a second mounting part 22. The first mounting part 21 is provided near the transparent convex surface to facilitate the encapsulation of the large-angle lens and the substrate, and the second mounting part 22 is provided near the transparent concave surface to facilitate the mounting and the fixing of the LED device.

This embodiment is different from the first embodiment in that, at the top of the main body the transparent convex surface includes a convex surface bulging toward the outside of the main body, and at the top of the main body the transparent concave surface includes a convex surface bulging toward the outside of the main body; the transparent concave surface includes a curved surface at its lower part, instead of a cylindrical surface, wherein the curved surface has a generating line being a concave function curve, with a slope gradually increasing from down to up, so that the thickness of the lower part of the main body is uneven. However, other conditions are still satisfied, for example, d1 and d2 still satisfy the relation: 4<d1/d2<6; the concave depth h1 of the transparent concave surface, i.e., the distance from the bottom to the highest point on the top of the transparent concave surface, and the thickness d2 of the center of the lens still satisfy the relation: h1>4*d2; and the convex height h2 of the transparent convex surface, i.e., the distance from the bottom to the highest point on the top of the transparent convex surface, and the thickness d2 of the center of the lens still satisfy the relation: h2>5*d2.

In this embodiment, the light rays are deflected through the two transparent surfaces, i.e., the transparent concave surface and the transparent convex surface. In this way, the light rays are redistributed, so that more light rays are deflected from the axis, and most of the light rays passing through the lens have an exit angle equal to or larger than the exit angle of the light rays emitted from the light-emitting surface.

### Third Embodiment of Large-angle Lens

Referring to Figs. 6 and 7, in this embodiment, the two large-angle lenses are manufactured integrally, each of which includes a main body 1 and a mounting part 2 provided under the main body 1. The main body 1 has an incident surface S1 and an exit surface S2 which both are provided with respect to a central axis circumferentially and symmetrically. The mounting part 2 includes a first mounting part 21 and a second mounting part 22. The first mounting part 21 is provided near the transparent convex surface to facilitate the encapsulation of the large-angle lens and the substrate, and the second mounting part 22 is provided near the transparent concave surface to facilitate the mounting and the fixing of the LED device.

This embodiment is different from the first embodiment in that, the top of the transparent convex surface includes a concave surface recessing the wall of the main body, rather than a flat surface, and the top of the transparent concave surface includes a convex surface bulging outward, rather than a flat surface. However, other conditions are still satisfied, for example, d1 and d2 still satisfy the relation: 4<d1/d2<6; the concave depth h1 of the transparent concave surface, i.e., the distance from the bottom to the highest point on the top of the transparent concave surface, and the thickness d2 of the center of the lens still satisfy the relation: h1>4*d2; and the convex height h2 of the transparent convex surface, i.e., the distance from the bottom to the highest point on the top of the transparent convex surface, and the thickness d2 of the center of the lens still satisfy the relation: h2>5*d2.

In this embodiment, the light rays are deflected through the two transparent surfaces, i.e., the transparent concave surface and the transparent convex surface. In this way, the light rays are redistributed, so that more light rays are deflected from the axis, and most of the light rays passing through the lens have an exit angle equal to or larger than the exit angle of the light rays emitted from the light-emitting surface.

In the large-angle lens in the above embodiments, the transparent convex surface includes a cylindrical surface at the lower part of the main body. Alternatively, in other embodiments, this surface can also be provided as a curved surface which has a generating line being an arc. Further, the generating line can be a concave function curve, with a slope gradually increasing from down to up.

### First Embodiment of Large-angle Emission LED Light Source Module

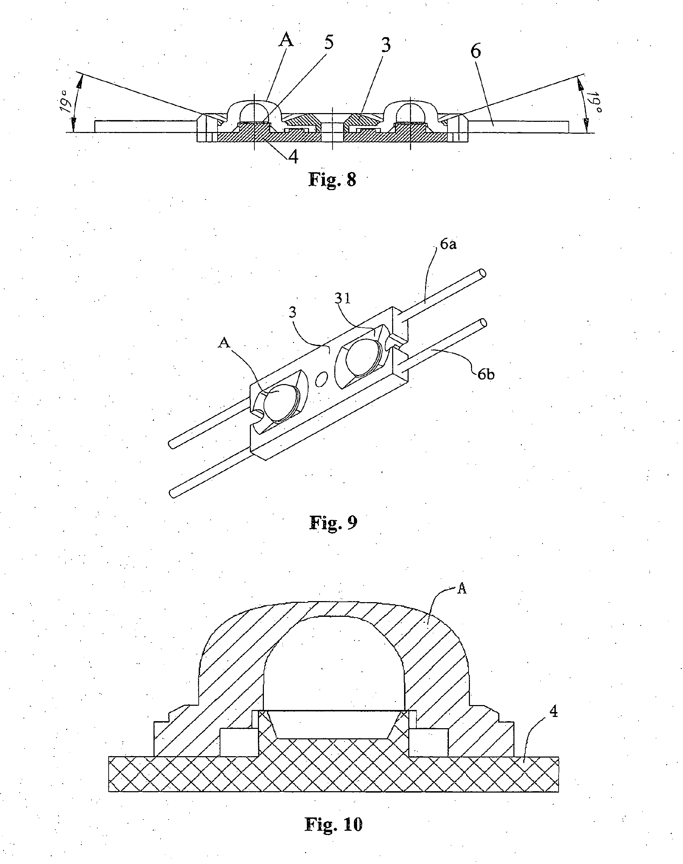

Referring to Figs. 8, 9 and 10, the large-angle emission LED light source module of this embodiment includes a substrate 4, two LED devices 5 provided on the substrate 4, a large-angle lens A, a plastic housing 3, and a power wire 6 connected to the substrate 4. Welding positions for the power wire are provided on the upper surface of the substrate, and a power input wire 6a and a power output wire 6b are provided at the two long edges of the upper surface of the substrate respectively, thereby achieving the connection between the substrate and the external power supply. An open groove 31 is formed at the outside of the plastic housing 3, and is provided around the large-angle lens A such that the exit surface of the large-angle lens A is exposed out of the bottom surface of the open groove without being covered by the plastic housing. The side wall of the open groove is composed of four inclined flat surfaces. Among these inclined flat surfaces, the two flat surfaces along the length direction of the LED light source module each are at an angle of 19° with respect to the bottom surface of the open groove, or in other embodiments, this angle can also be any value within the range of 15°~25°. The two flat surfaces along the width direction of the LED light source module each are at an angle of 49° with respect to the bottom surface of the open groove, or in other embodiments, this angle can also be any value within the range of 45°~52°. This structural arrangement facilitates the emission of the light.

The bottom surface of the large-angle lens A clings to the surface of the substrate tightly for covering the light-emitting surface of the LED device. The plastic housing 3 is formed of a molding material directly on the substrate, so as to encapsulate the large-angle lens A and the substrate, with the plastic housing 3 being formed on the surface of the substrate and around the substrate to cover the substrate 4. The forming process of the plastic housing can be the injection molding or the die-casting forming process. In this embodiment, because of the large-angle lens, the light-emitting angle is increased to 155°. The substrate in this embodiment is the metal core PCB plate. In this embodiment, the molding material for the plastic housing can be ABS resin. The structure of the large-angle lens A used in this embodiment is identical to that of the large-angle lens of the above first embodiment, which will not be described in detail herein.

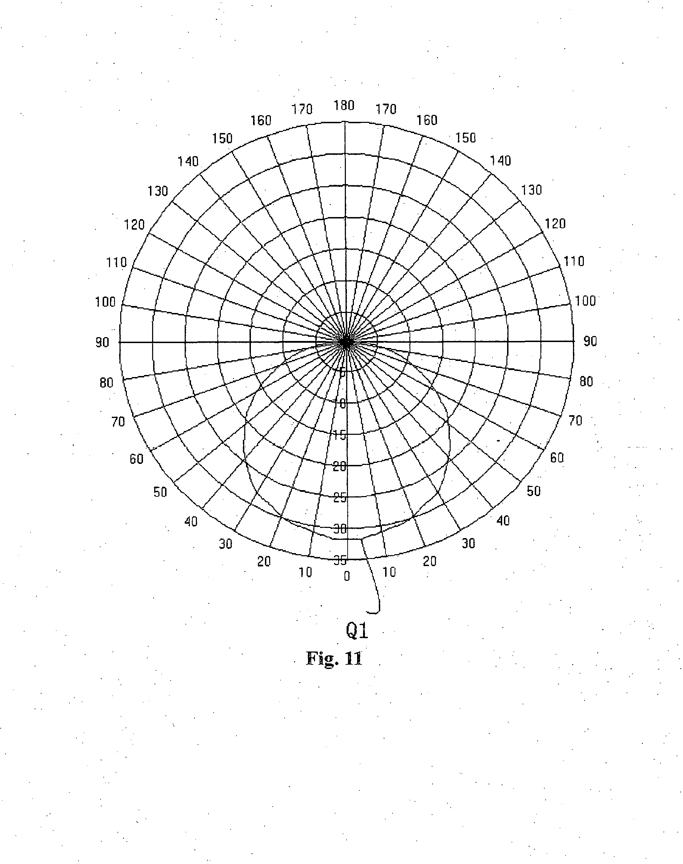

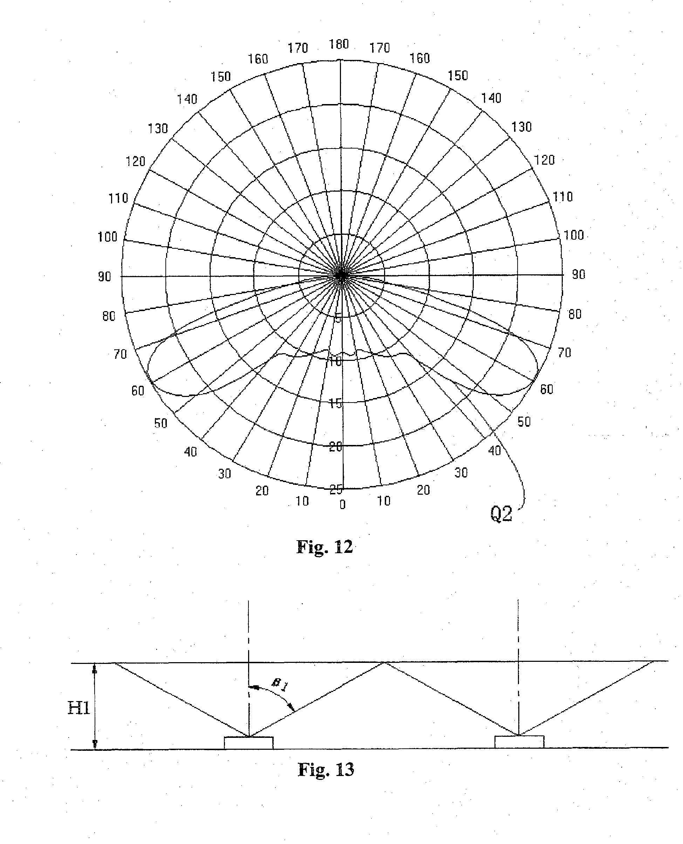

Referring to Fig. 11, if no large-angle lens is provided, the light distribution curve of the LED light source module conforms to Lambertian distribution, as the curve Q1 similar to a circle in the figure, in which the light beam angle is 110°~120°, and the parameters related to the emission of light are as follows: the efficiency being 1.0000-100000 light rays; the minimum of the light intensity being 4.8113e-013cd; the maximum of the light intensity being 31.683cd; and the total flux being 100lm. As shown in Fig. 12, the LED light source module with the large-angle lens in this embodiment has a light distribution curve being a bat wing shaped distribution curve Q2, in which the light beam angle is 130°~155°, and the parameters related to the emission of light are as follows: the efficiency being 0.90246-99572 light rays; the minimum of the light intensity being 2.5724e-013cd; the maximum of the light intensity being 24.87cd; and the total flux being 90.246lm. Compared with the Lambertian distribution curve, such a bat wing shaped light distribution curve is more prone to achieve the evenness of the lighting.

As shown in Fig. 13, before the large-angle lens is added, the light-emitting angle of the LED light source module itself is β1, and in practice, the height of H1 has to be obtained to ensure the evenness of the brightness of the light-emitting surface.

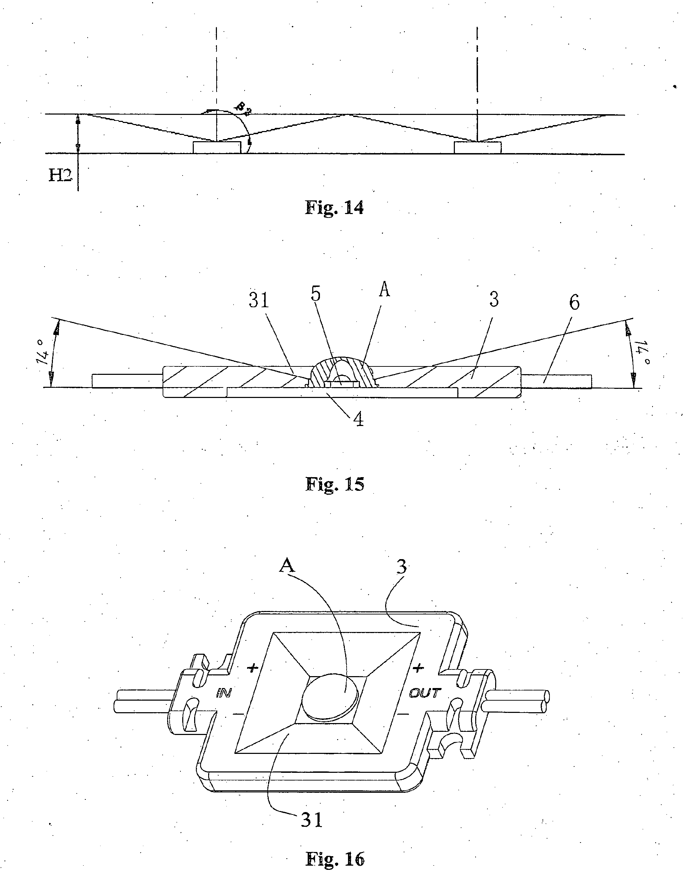

The light-emitting angle of the LED light source module is increased to β2 by adding the lens, so that decreasing the height of the light-emitting surface to H2 can also ensure the evenness of the brightness of the light-emitting surface, as shown in Fig. 14, which can decrease the height in actual application by the user, thereby saving the cost; alternatively, which can decrease the number of the LED light source module in the event that the height is not decreased in actual application, thereby reducing the number of the production and the labor cost for mounting.

In this embodiment, the LED device and the large-angle lens are enclosed by a plastic housing, thereby achieving the good moisture-proof and corrosion-proof performance, relieving the aging of the module, and satisfying the exhibition requirement in outdoor complex environment.

### Second Embodiment of Large-angle Emission LED Light Source Module

Referring to Figs. 15 and 16, this embodiment is different from the previous embodiment in that the large-angle lens used has a different structure. The lens adopted in this embodiment is of a lens structure of the large-angle lens in the second embodiment described above, which will not be described in detail herein. Besides, the inclined angle of the side wall flat surfaces of the open groove 31 in the plastic housing is different between this embodiment and the previous embodiment. The flat surfaces of the side wall of the open groove 31 in this embodiment each are at the same angle of 14° with respect to the bottom surface of the open groove. Alternatively, in other embodiments, this angle can also be any value within the range of 10°~16°.

### Third Embodiment of Large-angle Emission LED Light Source Module

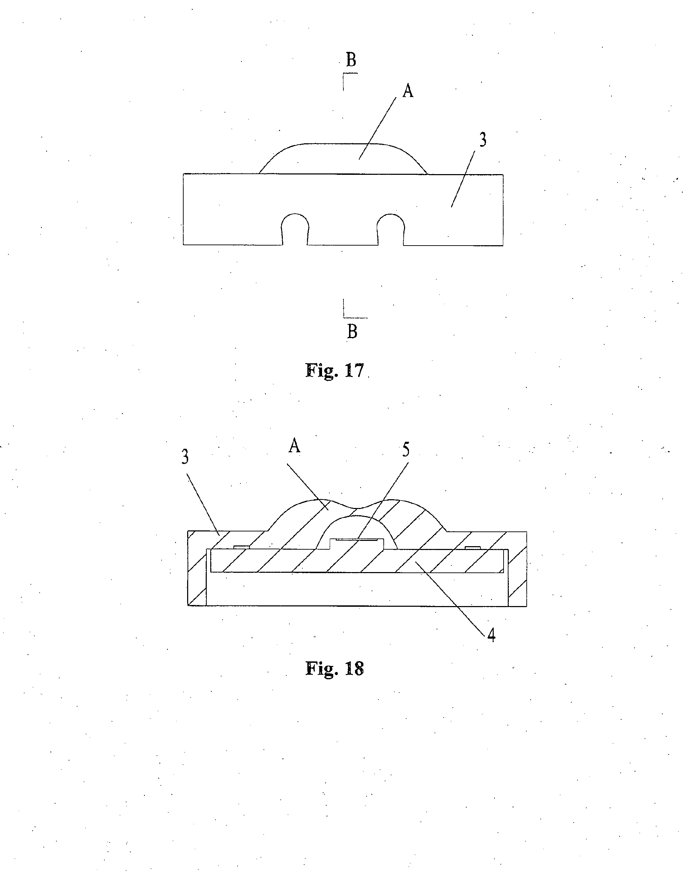

Referring to Figs. 17 and 18, the difference between this embodiment and the above two embodiments lies in that, in this embodiment, the plastic housing 3 and the large-angle lens A are integrally manufactured with the same material through an integral forming process. In such an integral structure of the large-angle lens and the plastic housing, the LED device 5 is encapsulated on the substrate 4.

Preferably, the plastic housing 3 and the large-angle lens A are made of the water-proof material.

Preferably, the light-emitting surface of the large-angle lens A is a frosted surface.

The structure of the large-angle lens A in this embodiment is similar to the structure of the large-angle lens in the third embodiment described above, in which the top of the transparent convex surface includes a concave surface recessing the wall of the main body rather than a flat surface, and the top of the transparent concave surface includes a curved surface bulging outward rather than a flat surface.

The disclosure has been described in detail above, and specific examples are adopted to describe the principle and the embodiment of the disclosure. The description of the above embodiments is only used to help understand the method of the disclosure and the core idea thereof. It should be noted that several modifications and improvements can be made by those skilled in the art without departing from the principle of the disclosure, and these modifications and improvements should be considered as falling within the scope of protection of the disclosure claimed in claims.

## Claims

1. A large-angle LED lens, comprising a shell-shaped main body with an opening at a lower end, the main body having an incident surface (S1) on an inner side of the main body and an exit surface (S2) on an outer side of the main body, both of the incident surface and the exit surface being provided symmetrically about a central axis of the main body, the incident surface being a transparent concave surface, the exit surface being a transparent convex surface, wherein
a maximum thickness d1 of the main body at a lower part and a minimum thickness d2 of the main body at the top satisfy the relation: 4<d1/d2<6;
a concave depth h1 of the transparent concave surface and the minimum thickness d2 of the main body at the top satisfy the relation: h1>4*d2; and
a convex height h2 of the transparent convex surface and the minimum thickness d2 of the main body at the top satisfy the relation: h2>5*d2,
**characterized in that** the transparent concave surface is configured to be changed gradually from a cylindrical surface at the lower half part into a spherical surface, and then changed into a flat surface at the top smoothly.

2. The large-angle LED lens according to claim 1, wherein the transparent convex surface is configured to be curved gradually towards the central axis of the main body from a cylindrical surface at the lower half part, and then changed into a flat surface at the top of the main body finally.

3. The large-angle LED lens according to claim 1, wherein the transparent convex surface is configured to have, at the top of the transparent convex surface, a concave surface recessed into a wall of the main body.

4. The large-angle LED lens according to claim 1, wherein a thickness of the main body gradually decreases from the lower part of the main body to the top of the main body.

5. The large-angle LED lens according to claim 1, wherein a mounting part is provided at the lower end of the main body, and a bottom of the mounting part being in contact with a substrate is provided with raised stripes.

6. The large-angle LED lens according to claim 1, wherein a mounting part is provided at the lower end of the main body, the mounting part comprises a first mounting part located under the transparent convex surface and a second mounting part located under the transparent concave surface, the first mounting part is of a stepped structure extending from a lower end of the outer side of the main body in a direction away from the central axis of the main body, and the second mounting part is of a concave structure extending from a lower end of the inner side of the main body in a direction away from the central axis of the main body.

7. A large-angle emission LED light source module, comprising a substrate, at least one LED device provided on the substrate, a large-angle LED lens according to claim 1 covering the LED device, and a plastic housing directly formed on the substrate for encapsulating the large-angle lens and the substrate, wherein an exit surface (S2) of the large-angle lens is exposed out of the plastic housing.

8. The large-angle emission LED light source module according to claim 7, wherein the large-angle lens clings to a surface of the substrate tightly for covering an entire light-emitting surface of the LED device, and the plastic housing is formed on an upper surface of the substrate and around the substrate by die-casting or injection molding, so as to encapsulate the large-angle lens and the substrate.

9. The large-angle emission LED light source module according to claim 7, wherein a mounting part is provided at the lower end of the main body, a lower end of the mounting part is in contact with the substrate, the mounting part comprises a first mounting part located under the transparent convex surface and a second mounting part located under the transparent concave surface, the fist mounting part is of a stepped structure extending from a lower end of the outer side of the main body in a direction away from the central axis of the main body, and the second mounting part is of a concave structure extending from a lower end of the inner side of the main body in a direction away from the central axis of the main body.

10. The large-angle emission LED light source module according to claim 7, wherein the substrate is a metal core PCB plate.

11. The large-angle emission LED light source module according to claim 7, wherein the plastic housing is formed with an open groove surrounding the large-angle lens, the exit surface of the large-angle lens is exposed out of a bottom surface of the groove, and side surfaces of the open groove are inclined with respect to the bottom surface of the open groove.

12. The large-angle emission LED light source module according to claim 11, wherein the side surfaces of the open groove are at an angle of 10°~52° with respect to the bottom surface of the open groove.

13. The large-angle emission LED light source module according to claim 7, wherein the large-angle lens and the plastic housing are formed integrally.

14. The large-angle emission LED light source module according to claim 7, wherein the transparent convex surface is configured to be curved gradually towards the central axis of the main body from a cylindrical surface at the lower half part, and then changed into a flat surface at the top of the main body finally.

15. The large-angle emission LED light source module according to claim 7, wherein the transparent convex surface is configured to have, at the top of the transparent convex surface, a concave surface recessed into a wall of the main body.

## Patentansprüche

1. Eine Grosswinkel-LED-Linse, aufweisend einen schalenförmigen Hauptkörper mit einer Öffnung an einem unteren Ende, wobei der Hauptkörper eine Einfallsfläche (S1) auf einer Innenseite des Hauptkörpers und eine Austrittsfläche (S2) auf einer Aussenseite des Hauptkörpers hat, wobei beide, die Einfallsfläche und die Austrittsfläche, symmetrisch um eine Zentralachse des Hauptkörpers vorgesehen sind, wobei die Einfallsfläche eine transparente konkave Oberfläche ist, wobei die Austrittsfläche eine transparente konvexe Oberfläche ist, wobei
eine maximale Dicke d1 des Hauptkörpers an einem unteren Teil und eine minimale Dicke d2 des Hauptkörpers an der Spitze die Beziehung: 4<dl/d2<6 erfüllen;
eine konkave Tiefe h1 der transparenten konkaven Oberfläche und die minimale Dicke d2 des Hauptkörpers an der Spitze die Beziehung: h1>4*d2 erfüllen; und
eine konvexe Höhe h2 der transparenten konvexen Oberfläche und die minimale Dicke d2 des Hauptkörpers an der Spitze die Beziehung: h2>5*d2 erfüllen,
**dadurch gekennzeichnet, dass** die transparente konkave Oberfläche so konfiguriert ist, dass sie allmählich von einer zylindrischen Oberfläche am unteren Halbteil in eine kugelförmige Oberfläche geändert wird, und dann stufenlos in eine flache Oberfläche an der Spitze geändert wird.

2. Grosswinkel-LED-Linse gemäss Anspruch 1, wobei die transparente konvexe Oberfläche so konfiguriert ist, dass sie in Richtung der Zentralachse des Hauptkörpers allmählich gekrümmt ist von einer zylindrischen Oberfläche am unteren Halbteil, und dann schlussendlich in eine flache Oberfläche an der Spitze des Hauptkörpers geändert wird.

3. Grosswinkel-LED-Linse gemäss Anspruch 1, wobei die transparente konvexe Oberfläche so konfiguriert ist, dass sie an der Spitze der transparenten konvexen Oberfläche eine konkave Oberfläche hat, welche in einer Wand des Hauptkörpers eingelassen ist.

4. Grosswinkel-LED-Linse gemäss Anspruch 1, wobei eine Dicke des Hauptkörpers vom unteren Teil des Hauptkörpers zu der Spitze des Hauptkörpers allmählich abnimmt.

5. Grosswinkel-LED-Linse gemäss Anspruch 1, wobei ein Befestigungsteil am unteren Ende des Hauptkörpers vorgesehen ist, und eine Unterseite des Befestigungsteils, welches in Kontakt mit einem Substrat ist, mit erhöhten Streifen versehen ist.

6. Grosswinkel-LED-Linse gemäss Anspruch 1, wobei ein Befestigungsteil am unteren Ende des Hauptkörpers vorgesehen ist, wobei das Befestigungsteil ein erstes Befestigungsteil aufweist, welches sich unter der transparenten konvexen Oberfläche befindet, und ein zweites Befestigungsteil aufweist, welches sich unter der transparenten konkaven Oberfläche befindet, wobei das erste Befestigungsteil eine Stufenstruktur hat, welche sich von einem unteren Ende der Aussenseite des Hauptkörpers in eine von der Zentralachse des Hauptkörpers wegführende Richtung erstreckt, und wobei das zweite Befestigungsteil eine konkave Struktur hat, welche sich von einem unteren Ende der Innenseite des Hauptkörpers in eine von der Zentralachse des Hauptkörpers wegführende Richtung erstreckt.

7. Ein Grosswinkel-Emissions-LED-Lichtquellenmodul, aufweisend ein Substrat, mindestens eine LED-Vorrichtung, welche auf dem Substrat vorgesehen ist, eine Grosswinkel-LED-Linse gemäss Anspruch 1, welche die LED-Vorrichtung bedeckt, und ein Kunststoffgehäuse, welches direkt auf dem Substrat ausgebildet ist, um die Grosswinkel-Linse und das Substrat einzukapseln, wobei eine Austrittsfläche (S2) der Grosswinkel-Linse aus dem Kunststoffgehäuse heraus freigelegt ist.

8. Grosswinkel-Emissions-LED-Lichtquellenmodul gemäss Anspruch 7, wobei die Grosswinkel-Linse fest an einer Oberfläche des Substrats haftet, um eine gesamte Licht-emittierende Oberfläche der LED-Vorrichtung zu bedecken, und wobei das Kunststoffgehäuse an einer oberen Oberfläche des Substrats und um das Substrat herum durch ein Druckguss oder Spritzgussverfahren ausgebildet ist, um die Grosswinkel-Linse und das Substrat zu verkapseln.

9. Grosswinkel-Emissions-LED-Lichtquellenmodul gemäss Anspruch 7, wobei ein Befestigungsteil am unteren Ende des Hauptkörpers vorgesehen ist, wobei ein unteres Ende des Befestigungsteils mit dem Substrat in Kontakt ist, wobei das Befestigungsteil ein erstes Befestigungsteil aufweist, welches sich unter der transparenten konvexen Oberfläche befindet, und ein zweites Befestigungsteil aufweist, welches sich unter der transparenten konkaven Oberfläche befindet, wobei das erste Befestigungsteil eine Stufenstruktur hat, welche sich von einem unteren Ende der Aussenseite des Hauptkörpers in eine von der Zentralachse des Hauptkörpers wegführende Richtung erstreckt, und wobei das zweite Befestigungsteil eine konkave Struktur hat, welche sich von einem unteren Ende der Innenseite des Hauptkörpers in eine von der Zentralachse des Hauptkörpers wegführende Richtung erstreckt.

10. Grosswinkel-Emissions-LED-Lichtquellenmodul gemäss Anspruch 7, wobei das Substrat eine Metallkern-PCB-Platte ist.

11. Grosswinkel-Emissions-LED-Lichtquellenmodul gemäss Anspruch 7, wobei das Kunststoffgehäuse mit einer offenen Nut ausgebildet ist, welche die Grosswinkel-Linse umgibt, wobei die Austrittsfläche der Grosswinkel-Linse aus einer Bodenfläche der Nut heraus freigelegt ist, und wobei Seitenflächen der offenen Nut bezüglich der Bodenfläche der offenen Nut geneigt sind.

12. Grosswinkel-Emissions-LED-Lichtquellenmodul gemäss Anspruch 11, wobei die Seitenflächen der offenen Nut in einem Winkel von 10° ~ 52° bezüglich der Bodenfläche der offenen Nut sind.

13. Grosswinkel-Emissions-LED-Lichtquellenmodul gemäss Anspruch 7, wobei die Grosswinkel-Linse und das Kunststoffgehäuse einstückig ausgebildet sind.

14. Grosswinkel-Emissions-LED-Lichtquellenmodul gemäss Anspruch 7, wobei die transparente konvexe Oberfläche so konfiguriert ist, dass sie in Richtung der Zentralachse des Hauptkörpers allmählich gekrümmt ist von einer zylindrischen Oberfläche am unteren Halbteil, und dann schlussendlich in eine flache Oberfläche an der Spitze des Hauptkörpers geändert wird.

15. Grosswinkel-Emissions-LED-Lichtquellenmodul gemäss Anspruch 7, wobei die transparente konvexe Oberfläche so konfiguriert ist, dass sie an der Spitze der transparenten konvexen Oberfläche eine konkave Oberfläche hat, welche in einer Wand des Hauptkörpers eingelassen ist.

## Revendications

1. Une lentille LED à grand angle, comprenant un corps principal en forme de coque ayant une ouverture sur son extrémité inférieure, le corps principal ayant une surface incidente (S1) sur un côté intérieur du corps principal et une surface de sortie (S2) sur un côté extérieur du corps principal, la surface incidente ainsi que la surface de sortie étant prévues autour d'un axe central du corps principal, la surface incidente étant une surface transparente concave, la surface de surface de sortie étant une surface transparente convexe, dans laquelle,
une épaisseur maximale d1 du corps principal à une partie inférieure et une épaisseur minimale d2 du corps principal à une partie supérieure satisfont la relation 4 <d1/d2<6 ;
une profondeur concave h1 de la surface transparente concave et l'épaisseur minimum d2 du corps principal à une partie supérieure satisfont la relation h1>4*d2 ; et
une hauteur convexe h2 de la surface transparente convexe et l'épaisseur minimum d2 du corps à la partie supérieure satisfont la relation h2>5*d2,
**caractérisée en ce que** la surface transparente concave est configurée pour être changée graduellement depuis une surface cylindrique à la semi-partie inférieure en une surface sphérique, et ensuite être changée en une surface plane à la partie supérieure de manière souple.

2. La lentille LED à grand angle selon la revendication 1, dans laquelle la surface transparente convexe est configurée pour être graduellement courbée vers un axe central du corps principal depuis une surface cylindrique à la semi-partie inférieure, et ensuite être changée en une surface plane à la partie supérieure du corps principal de manière finale.

3. La lentille LED à grand angle selon la revendication 1, dans laquelle la surface transparente convexe est configurée pour avoir une surface concave encastrée dans la paroi du corps principal à la partie supérieure de la surface transparente convexe.

4. La lentille LED à grand angle selon la revendication 1, dans laquelle l'épaisseur du corps principal diminue graduellement depuis la partie inférieure du corps principal vers la partie supérieure du corps principal.

5. La lentille LED à grand angle selon la revendication 1, dans laquelle une partie de montage est prévue à l'extrémité inférieure du corps principal, et une partie inférieure de la partie de montage étant en contact avec un substrat et pourvue de bandes surélevées.

6. La lentille LED à grand angle selon la revendication 1, dans laquelle une partie de montage est prévue à l'extrémité inférieure du corps principal, la partie de montage comprend une première partie de montage située sous la surface transparente convexe et une seconde partie de montage située sous la surface transparente concave, la première partie de montage est une structure échelonnée s'étendant depuis une extrémité inférieure du côté extérieur du corps principal vers une direction s'éloignant de l'axe central du corps principal, et la seconde partie de montage est une structure concave s'étendant depuis une extrémité inférieure du côté intérieure du corps principale en une direction s'éloignant de l'axe central du corps principal.

7. Un module source à lumière LED à émission à grand angle, comprenant un substrat, au moins un dispositif LED prévu sur le substrat, une lentille LED à grand angle selon la revendication 1 couvrant le dispositif LED, et un boîtier en plastique formé directement sur le substrat pour encapsuler la lentille à grande angle et le substrat, dans lequel une surface de sortie (S2) de la lentille à grande angle est exposée hors du boîtier en plastique.

8. Le module source à lumière LED à émission à grand angle selon la revendication 7, dans lequel la lentille à grand angle s'accroche à la surface du substrat de manière serrée pour couvrir la surface émettant la lumière du dispositif LED entièrement, et le boîtier en plastique est formé sur une surface supérieure du substrat et autour du substrat par injection moulage ou coulée sous pression, de manière à encapsuler la lentille à grand angle et le substrat.

9. Le module source à lumière LED à émission à grand angle selon la revendication 7, dans lequel une partie de montage est prévue à l'extrémité inférieure du corps principal, une extrémité inférieure de la partie de montage est en contact avec le substrat, la partie de montage comprend une première partie de montage située sous la surface transparente convexe et une seconde partie de montage située sous la surface transparente concave, la première partie de montage a une structure échelonnée s'étendant depuis l'extrémité inférieure du côté extérieure du corps principal en une direction s'éloignant de l'axe central du corps principal, et la seconde partie de montage a une structure concave s'étendant depuis une extrémité inférieure du côté intérieur du corps principale en une direction s'éloignant de l'axe central du corps principal.

10. Le module source à lumière LED à émission à grande angle selon la revendication 7, dans lequel le substrat est une plaque à circuit imprimé ayant un noyau en métal.

11. Le module source à lumière LED à émission à grand angle selon la revendication 7, dans lequel le boîtier en plastique est formé avec une rainure ouverte entourant la lentille à grande angle, la surface de sortie de la lentille à grande angle est exposée hors de la surface inférieure de la rainure, et des surfaces latérales de la rainure ouverte sont inclinées par rapport à la surface inférieure de la rainure ouverte.

12. Le module source à lumière LED à émission à grande angle selon la revendication 11, dans lequel les surfaces latérales de la rainure ouverte ont des angles de 10° à 52° par rapport à la surface inférieure de la rainure ouverte.

13. Le module source à lumière LED à émission à grand angle selon la revendication 7, dans lequel la lentille à grand angle et le boîtier en plastique sont formés de manière intégrale.

14. Le module source à lumière LED à émission à grand angle selon la revendication 7, dans lequel la surface transparente convexe est configurée pour être graduellement courbée vers l'axe central du corps principal depuis une surface cylindrique à la semi-partie inférieure, et ensuite changée en une surface plane à la partie supérieure du corps principal de manière finale.

15. Le module source à lumière LED à émission à grande angle selon la revendication 7, dans lequel la surface transparente convexe est configurée pour avoir une surface concave encastrée dans une paroi du corps principal à la partie supérieure de la surface transparente convexe.
